# EUROPEAN PATENT APPLICATION

(11) **EP 4 560 690 A1**
(43) Date of publication of application: **28.05.2025**
(21) Application number: 24182572.8
(22) Date of filing: 17.06.2024
(51) Int. Cl.: H01L 21/8234, H01L 21/8238, H01L 29/06, H01L 29/08, H01L 29/66, H01L 29/775, H01L 21/822, H01L 27/06, H01L 27/092, B82Y 10/00, H01L 29/417

(54) **SEMICONDUCTOR DEVICE**

(30) Priority: 23.11.2023 KR 20230164857
(71) Applicant: Samsung Electronics Co., Ltd., Suwon-si, Gyeonggi-do 16677 (KR)
(72) Inventor: ZOH, Inhae, 16677 Suwon-si (KR); KIM, Jinbum, 16677 Suwon-si (KR); YANG, Suk, 16677 Suwon-si (KR); HAN, Soobin, 16677 Suwon-si (KR)
(74) Representative: Marks & Clerk LLP

(57) **Abstract**

A semiconductor device of the technical idea of the inventive concept includes a first transistor including a first channel region extending in a first direction and a first source/drain region contacting the first channel region, a second transistor including a second channel region on the first transistor and spaced apart from the first transistor in a second direction perpendicular to the first direction and extending in the first direction and a second source/drain region contacting the second channel region, a dummy layer beneath the first transistor, a protective layer beneath the dummy layer and including an indented portion that is indented in the first direction, and a spacer on the indented portion.

## Description

### BACKGROUND OF THE INVENTION

The technical idea of the inventive concept relates to a semiconductor device, and more particularly, to a semiconductor device including a field-effect transistor.

As the down-scaling of semiconductor devices progresses rapidly, there is a need to secure not only a high operation speed but also an operation accuracy in the semiconductor devices. Also, as the integration degree of the semiconductor devices increases and the size thereof decreases, the possibility of process defects occurring during a process of manufacturing field effect transistors may increase. Accordingly, there is a need to develop semiconductor devices with new structures capable of eliminating the possibility of process defects and improving the performance and reliability of the field effect transistors.

### SUMMARY OF THE INVENTION

A task to be solved by the technical idea of the inventive concept is to provide an improved semiconductor device with an improved electrical characteristic by preventing a stacking fault.

The task to be solved by the technical idea of the inventive concept is not limited to the task mentioned above, and other tasks not mentioned will be clearly understood by those skilled in the art from the description below.

A semiconductor device of the technical idea of the inventive concept include a first transistor including a first channel region extending in a first direction and a first source/drain region contacting the first channel region, a second transistor including a second channel region on the first transistor and spaced apart from the first transistor in a second direction perpendicular to the first direction and extending in the first direction, and a second source/drain region contacting the second channel region, a dummy layer beneath the first transistor, a protective layer beneath the dummy layer and including an indented portion that is indented in the first direction, and a spacer on the indented portion.

A semiconductor device of the technical idea of the inventive concept include a first transistor including a first channel region extending in a first direction and a first source/drain region contacting the first channel region, a second transistor including a second channel region on the first transistor and spaced apart from the first transistor in a second direction perpendicular to the first direction and extending in the first direction, and a second source/drain region contacting the second channel region, a dummy layer beneath the first transistor and including a sidewall that is indented in the first direction, a protective layer beneath the dummy layer and including a sidewall that is indented in the first direction, and a spacer on the sidewall of the protective layer and on the sidewall of the dummy layer.

A semiconductor device of the technical idea of the inventive concept include a first transistor including a first channel region including a plurality of first nanosheets extending in a first direction and spaced apart from each other in a second direction perpendicular to the first direction, a first source/drain region contacting the first channel region, and a plurality of first gate lines surrounding the plurality of first nanosheets, a second transistor including a second channel region on the first transistor and spaced apart from the first transistor in the second direction and including a plurality of second nanosheets spaced apart from each other in the second direction, a second source/drain region contacting the second channel region, and a plurality of second gate lines spaced apart from each other with the second nanosheets located therebetween, an insulating layer between the first transistor and the second transistor and insulating the first transistor and the second transistor from each other, a contact electrode beneath the first source/drain region, a dummy layer beneath the first transistor, a protective layer beneath the dummy layer and including a sidewall that is indented in the first direction, and a spacer on the sidewall.

On may refer to an element being directly or indirectly proximate another element in a direction, e.g., the first or second direction. For example, the second transistor may be proximate the first transistor in a direction, e.g., the second direction. The second transistor may be spaced apart from the first transistor in the second direction. As a further example, the spacer may be proximate the protective layer, and optionally the dummy layer, in the first direction.

Beneath may refer to an element being directly or indirectly proximate another element in a direction, e.g., the second direction. For example, the protective layer may be proximate, directly or indirectly, the first transistor in the second direction.

As used herein, the term indented may refer to a portion (e.g., a sidewall) of a layer that is laterally recessed/offset relative to another layer. The lateral recess/offset may be in a direction, e.g., the first direction.

The first direction may be a horizontal direction. The second direction may be a vertical direction. The first direction may be X direction. The second direction may be Z direction.

At least some of the above and other features of the disclosure are set out in the claims.

### BRIEF DESCRIPTION OF THE DRAWINGS

Embodiments will be more clearly understood from the following detailed description taken in conjunction with the accompanying drawings in which:
FIG. 1 is a cross-sectional diagram illustrating a semiconductor device according to an embodiment;
FIG. 2 is a cross-sectional diagram illustrating a semiconductor device according to an embodiment;
FIGS. 3A to 3L are cross-sectional diagrams illustrating a process sequence to explain a method of manufacturing a semiconductor device according to an embodiment; and
FIGS. 4A to 4C are cross-sectional views illustrating a process sequence to explain a method of manufacturing a semiconductor device according to other embodiments.

### DETAILED DESCRIPTION

Embodiments of the technical idea of the inventive concept will be described below in detail with reference to the attached drawings.

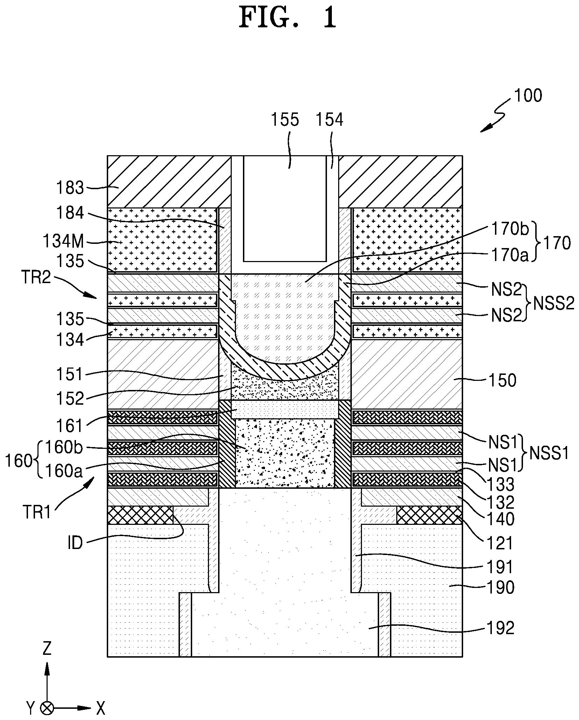

FIG. 1 is a cross-sectional diagram illustrating a semiconductor device according to an embodiment.

Referring to FIG. 1, a semiconductor device 100 may include a protective layer 121, a dummy layer 140 formed on the protective layer 121, a first transistor TR1 formed on the dummy layer 140, and a second transistor TR2. For example, the first transistor TR1 may include a PMOS transistor, and the second transistor TR2 may include an NMOS transistor.

The first transistor TR1 may include a first nanosheet stack NSS1. The first nanosheet stack NSS1 may include a plurality of first nanosheets NS 1 that overlap each other in a vertical direction (a Z direction). The nanosheets should be understood as including nanowires. The plurality of first nanosheets NS1 may be spaced apart from each other in the vertical direction (the Z direction) and have different vertical distances (Z direction distances) from the dummy layer 140.

The second transistor TR2 may include a second nanosheet stack NSS2. The second nanosheet stack NSS2 may include a plurality of second nanosheets NS2 that overlap each other in the vertical direction (the Z direction). The plurality of second nanosheets NS2 may be spaced apart from each other in the vertical direction (the Z direction) and have different vertical distances (Z direction distances) from the dummy layer 140.

FIG. 1 illustrates a case where the first nanosheet stack NSS1 and the second nanosheet stack NSS2 include two first nanosheets NS1 and two second nanosheets NS2, respectively, but the technical idea of the inventive concept is not limited thereto. The number of nanosheets constituting the first nanosheet stack NSS 1 and the second nanosheet stack NSS2 is not particularly limited. For example, the first nanosheet stack NSS1 and the second nanosheet stack NSS2 may also include one, three, four or more nanosheets, respectively. The plurality of first nanosheets NS1 and the plurality of second nanosheets NS2 each may have/provide a channel region. For example, the plurality of first nanosheets NS 1 and the plurality of second nanosheets NS2 each may have a thickness selected from a range of about 5 nanometers (nm) to about 10 nm, but are not limited thereto. Here, the thickness of the plurality of first nanosheets NS1 and the plurality of second nanosheets NS2 refers to a size shown in the vertical direction (the Z direction). In some embodiments, the plurality of first nanosheets NS1 and the plurality of second nanosheets NS2 may have substantially the same thickness in the vertical direction (the Z direction). In other embodiments, at least some of the plurality of first nanosheets NS1 and the plurality of second nanosheets NS2 may have different thicknesses in the vertical direction (the Z direction).

In some embodiments, the plurality of first nanosheets NS1 included in the first nanosheet stack NSS 1 each may have the same size in a first horizontal direction (an X direction). In other embodiments, at least some of the plurality of first nanosheets NS1 included in the first nanosheet stack NSS1 may have different sizes in the first horizontal direction (the X direction). The X and Z directions may be perpendicular to each other.

In some embodiments, the plurality of second nanosheets NS2 included in the second nanosheet stack NSS2 each may have the same size in the first horizontal direction (the X direction). In other embodiments, at least some of the plurality of second nanosheets NS2 included in the second nanosheet stack NSS2 may have different sizes in the first horizontal direction (the X direction).

In this specification, the plurality of first nanosheets NS 1 of the first nanosheet stack NSS1 included in the first transistor TR1 may be referred to as a first channel region, and the plurality of second nanosheets NS2 or the second nanosheet stack NSS2 included in the second transistor TR2 may be referred to as a second channel region.

The plurality of first nanosheets NS 1 may be made of semiconductor layers made from the same element. In some embodiments, the plurality of first nanosheets NS1 each may be made of an undoped silicon layer. In other embodiments, the plurality of first nanosheets NS1 each may be made of a doped silicon layer.

The plurality of second nanosheets NS2 may be made of semiconductor layers made from the same element. In some embodiments, the plurality of second nanosheets NS2 each may be made of an undoped silicon layer. In other embodiments, the plurality of second nanosheets NS2 each may be made of a doped silicon layer.

For example, in the first transistor TR1, the plurality of first nanosheets NS1 may be made of silicon layers doped with n-type dopants, and in the second transistor TR2, the plurality of second nanosheets NS2 may be made of silicon layers doped with p-type dopants, but are not limited thereto. The n-type dopant may be selected from phosphorus (P), arsenic (As), and antimony (Sb). The p-type dopant may be selected from boron (B) and gallium (Ga).

The first transistor TR1 may include a first source/drain region 160. The first source/drain region 160 may contact each of the plurality of first nanosheets NS1 disposed adjacent to the first source/drain region 160. The second transistor TR2 may include a second source/drain region 170. The second source/drain region 170 may contact each of the plurality of second nanosheets NS2 disposed adjacent to the second source/drain region 170.

The first source/drain region 160 may include silicon germanium (SiGe) formed in an epitaxial growth method. The first source/drain region 160 may include a first semiconductor layer 160a and a second semiconductor layer 160b disposed inside the first semiconductor layer 160a. In some embodiments, the first semiconductor layer 160a may include silicon germanium (SiGe) formed in the epitaxial growth method, and the second semiconductor layer 160b may also include silicon germanium (SiGe) formed in the epitaxial growth method. In this case, a germanium (Ge) content ratio of the second semiconductor layer 160b may be smaller than a germanium (Ge) content ratio of the first semiconductor layer 160a.

The first semiconductor layer 160a and the second semiconductor layer 160b may include materials obtained by doping, with p-type dopants, the silicon germanium (SiGe) formed in the epitaxial growth method. In some embodiments, the first semiconductor layer 160a may include a material obtained by doping, with boron (B), the silicon germanium (SiGe) formed in the epitaxial growth method, and the second semiconductor layer 160b may also include a material obtained by doping, with boron (B), the silicon germanium (SiGe) formed in the epitaxial growth method. In this case, a boron (B) doping concentration of the second semiconductor layer 160b may be lower than a boron (B) doping concentration of the first semiconductor layer 160a.

The second source/drain region 170 may include silicon formed in the epitaxial growth method. The second source/drain region 170 may include a third semiconductor layer 170a and a fourth semiconductor layer 170b disposed inside the third semiconductor layer 170a. The third semiconductor layer 170a and the fourth semiconductor layer 170b may include silicon doped with an n-type dopant. In some embodiments, the third semiconductor layer 170a and the fourth semiconductor layer 170b may include silicon doped with phosphorus (P). The third semiconductor layer 170a may be doped with a lower concentration of dopant than the fourth semiconductor layer 170b and impede/prevent a short channel effect.

In FIG. 1, the second source/drain region 170 is shown as including the two semiconductor layers, but is not limited thereto. In some embodiments, the second source/drain region 170 may include a plurality of semiconductor layers.

In some embodiments, the third semiconductor layer 170a may include a material obtained by doping, with phosphorus (P), the silicon formed in the epitaxial growth method, and the fourth semiconductor layer 170b may also include a material obtained by doping, with phosphorus (P), the silicon formed in the epitaxial growth method.

The first transistor TR1 may include a plurality of first gate lines 132 spaced apart with the first nanosheets NS1 located therebetween. The second transistor TR2 may include a plurality of second gate lines 134 spaced apart with the second nanosheets NS2 located therebetween.

The first gate line 132 and the second gate line 134 may each independently be made of metal, metal nitride, metal carbide, or a combination thereof. The metal may be selected from titanium (Ti), tungsten (W), ruthenium (Ru), niobium (Nb), molybdenum (Mo), Hafnium (Hf), nickel (Ni), cobalt (Co), platinum (Pt), ytterbium (Yb), terbium (Tb), dysprosium (Dy), erbium (Er), and palladium (Pd). The metal nitride may be selected from titanium nitride (TiN) and tantalum nitride (TaN). The metal carbide may be titanium aluminum carbide (TiAlC). In some embodiments, the first gate line 132 and the second gate line 134 each independently have a structure in which a metal nitride film, a metal film, a conductive capping film, and a gap-fill metal film are sequentially stacked. The metal nitride film and the metal film may include at least one metal selected from titanium (Ti), tantalum (Ta), tungsten (W), ruthenium (Ru), niobium (Nb), molybdenum (Mo), and hafnium (Hf). The gap-fill metal film may be made of a tungsten (W) film or an aluminum (Al) film. The plurality of first gate lines 132 and the plurality of second gate lines 134 may include at least one work function metal-containing film. The at least one work function metal-containing film may include at least one metal selected from titanium (Ti), tungsten (W), ruthenium (Ru), niobium (Nb), Molybdenum (Mo), Hafnium (Hf), nickel (Ni), cobalt (Co), platinum (Pt), ytterbium (Yb), terbium (Tb), dysprosium (Dy), erbium (Er), and palladium (Pd). In some embodiments, the first gate line 132 and the second gate line 134 may include a stacked structure of titanium aluminum carbide / titanium nitride /tungsten (TiAlC/TiN/W), a stacked structure of titanium nitride / tantalum nitride / titanium aluminum carbide / titanium nitride / tungsten (TiN/TaN/TiAlC/TiN/W), or a stacked structure of titanium nitride / tantalum nitride / titanium nitride / titanium aluminum carbide / titanium nitride / tungsten (TiN/TaN/TiN/TiAlC/TiN/W), but are not limited to the above example. In some embodiments, the first gate line 132 and the second gate line 134 may have different thicknesses, different materials, or different stacked structures.

In the first transistor TR1, the first nanosheet NS1 may be surrounded by a first gate dielectric film 133, and the first gate dielectric film 133 may be surrounded by a first gate line 132. In the second transistor TR2, the second nanosheet NS2 may be surrounded by a second gate dielectric film 135, and the second gate dielectric film 135 may be surrounded by the second gate line 134. Accordingly, the first gate line 132 may surround the first nanosheet NS1, and the second gate line 134 may surround the second nanosheet NS2. Moreover, the first gate dielectric film 133 may be between the first gate line 132 and the first nanosheet NS1, and the second gate dielectric film 135 may be between the second gate line 134 and the second nanosheet NS2.

In some embodiments, the first gate dielectric film 133 and the second gate dielectric film 135 may be made of a high dielectric film. The high dielectric film may be made from a material having a greater dielectric constant than a silicon oxide film. For example, the high dielectric film may have a dielectric constant of about 10 to 25. The high dielectric film may be made of hafnium oxide, but is not limited thereto. In some embodiments, the first gate dielectric film 133 and the second gate dielectric film 135 may have different thicknesses, different materials, or different stacked structures.

In the first transistor TR1, an upper surface of the first source/drain region 160 may be covered with a semiconductor capping layer 161. In some embodiments, the semiconductor capping layer 161 may be made of undoped silicon, silicon doped with a p-type dopant, or silicon germanium (SiGe) having a germanium (Ge) content ratio that is smaller than that in the second semiconductor layer 160b.

The first source/drain region 160 of the first transistor TR1 and the second source/drain region 170 of the second transistor TR2 may have different shapes and sizes. The shape and size of the first source/drain region 160 of the first transistor TR1 and the second source/drain region 170 of the second transistor TR2 are not limited to those illustrated in FIG. 1, and the size and shape of the first source/drain region 160 and the second source/drain region 170 may be modified in various ways.

An insulating layer 150 may be disposed between the first transistor TR1 and the second transistor TR2 and insulate the first transistor TR1 and the second transistor TR2 from each other. In some embodiments, the insulating layer 150 may be made of a silicon nitride film, a silicon oxide film, silicon oxynitride (SiON), silicon oxycarbonitride (SiOCN), or a combination thereof.

The first source/drain region 160 may be spaced apart from the second source/drain region 170 with a first insulating film 151 and a second insulating film 152 located therebetween. In some embodiments, the first insulating film 151 and the second insulating film 152 may each independently be made of a silicon nitride film, a silicon oxide film, silicon oxynitride (SiON), silicon oxycarbonitride (SiOCN), or a combination thereof.

The protective layer 121 may serve to protect the first source/drain region 160 when a silicon layer is etched in a process of manufacturing the semiconductor device 100. The thickness of the protective layer 121 may be, for example, about 5 nm or more and about 10 nm or less. The thickness of the protective layer 121 may be, for example, about 1 nm or more and about 20 nm or less.

The protective layer 121 may be made of a semiconductor material layer formed in the epitaxial growth method. The protective layer 121 may include silicon germanium or a material obtained by adding carbon to the silicon germanium. For example, the protective layer 121 may include silicon germanium and carbon.

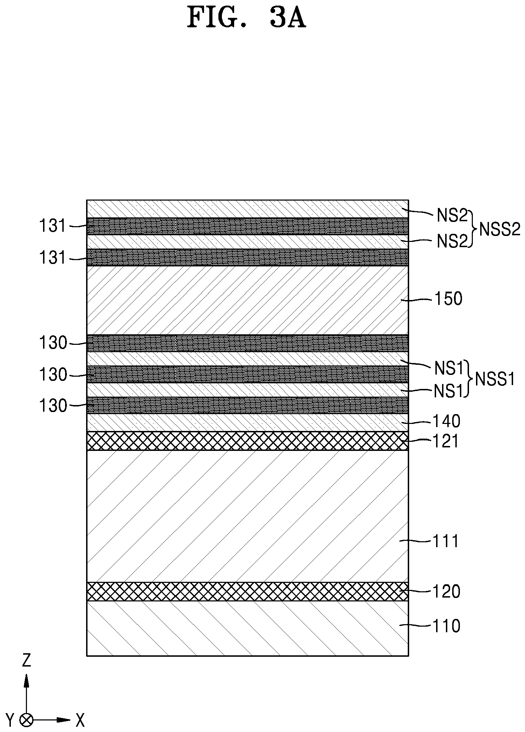

Also, as the protective layer 121 includes the silicon germanium or the material obtained by adding the carbon to the silicon germanium, the protective layer 121 may have the same crystal structure as a substrate including silicon (referring to 110 of FIG. 3A) and/or a dummy layer 140 including silicon. As the first source/drain region 160 grows within the same crystal structure, the occurrence of stacking faults may be reduced/prevented.

An indented structure ID may be formed in the protective layer 121. The indented structure ID may be, for example, an opening in the protective layer 121. The indented structure ID formed in the protective layer 121 may have a spacer 191 therein (e.g., the indented structure ID may be filled with the spacer 191). The protective layer 121 may be indented (by/because of the indented structure ID) in the X direction relative to the dummy layer 140 (and relative to a gap-fill oxide layer 190). For example, an inner sidewall of the protective layer 121 may be indented in the X direction relative to an inner sidewall of the dummy layer 140 (and relative to an inner sidewall of the gap-fill oxide layer 190). The inner sidewall of the protective layer 121 may thus be part of an indented portion of the protective layer 121. The spacer 191 may be on the indented portion (e.g., may contact the inner sidewall) of the protective layer 121. The spacer 191 may include silicon nitride (SiN), but is not limited thereto. The spacer 191 may include, for example, silicon nitride (SiN), silicon dioxide (SiO₂), silicon oxycarbide (SiOC), silicon oxycarbonitride (SiOCN), or silicon oxynitride (SiON). A portion of the spacer 191 may protrude in the X direction toward the indented portion (e.g., the inner sidewall) of the protective layer 121.

The dummy layer 140 may be disposed on the protective layer 121. The dummy layer 140 may include silicon. For example, the thickness of the dummy layer 140 may be about 10 nm or more and about 20 nm or less. As another example, the thickness of the dummy layer 140 may be about 5 nm or more and about 50 nm or less.

A gap-fill oxide layer 190 may be disposed beneath the protective layer 121. The gap-fill oxide layer 190 may fill a space where a silicon layer is etched out during the process of manufacturing the semiconductor device 100. The gap-fill oxide layer 190 may include silicon dioxide (SiO₂), for example.

A contact electrode 192 may be disposed beneath the first source/drain region 160. The contact electrode 192 may be surrounded by the spacer 191. The contact electrode 192 may be made of metal, conductive metal nitride, or a combination thereof. The contact electrode 192 may be made of, for example, tungsten (W), molybdenum (Mo), copper (Cu), Al, titanium (Ti), tantalum (Ta), titanium nitride (TiN), tantalum nitride (TaN), an alloy thereof, or a combination thereof.

A main gate line 134M and the second gate dielectric film 135 contacting the main gate line 134M may be disposed on the uppermost second nanosheet NS2. The main gate line 134M may be made of metal, metal nitride, metal carbide, or a combination thereof. The metal may be selected from titanium (Ti), tungsten (W), ruthenium (Ru), niobium (Nb), molybdenum (Mo), hafnium (Hf), nickel (Ni), cobalt (Co), platinum (Pt), ytterbium (Yb), terbium (Tb), dysprosium (Dy), erbium (Er), and palladium (Pd). The metal nitride may be selected from titanium nitride (TiN) and tantalum nitride (TaN). The metal carbide may be titanium aluminum carbide (TiAlC). In some embodiments, the main gate line 134M may have a structure in which a metal nitride film, a metal film, a conductive capping film, and a gap-fill metal film are sequentially stacked. The metal nitride film and the metal film may include at least one metal selected from titanium (Ti), tantalum (Ta), tungsten (W), ruthenium (Ru), niobium (Nb), molybdenum (Mo), and hafnium (Hf). The gap-fill metal film may be made of a tungsten (W) film or an aluminum (Al) film. The main gate line 134M may include at least one work function metal-containing film. The at least one work function metal-containing film may include at least one metal selected from titanium (Ti), tungsten (W), ruthenium (Ru), niobium (Nb), molybdenum (Mo), hafnium (Hf), nickel (Ni), cobalt (Co), platinum (Pt), ytterbium (Yb), terbium (Tb), dysprosium (Dy), erbium (Er), and palladium (Pd). In some embodiments, the main gate line 134M may include a stacked structure of titanium aluminum carbide / titanium nitride /tungsten (TiAlC/TiN/W), a stacked structure of titanium nitride / tantalum nitride / titanium aluminum carbide / titanium nitride / tungsten (TiN/TaN/TiAlC/TiN/W), or a stacked structure of titanium nitride / tantalum nitride / titanium nitride / titanium aluminum carbide / titanium nitride / tungsten (TiN/TaN/TiN/TiAlC/TiN/W), but is not limited to the above example. An upper surface of each of the plurality of main gate lines 134M may be covered with a capping insulating pattern 183. The capping insulating pattern 183 may be made of a silicon nitride film. A sidewall of the main gate line 134M may be covered by an insulating spacer 184. The insulating spacer 184 may be spaced apart from the main gate line 134M with the second gate dielectric film 135 located therebetween. The insulating spacer 184 may be made of silicon nitride (SiN), silicon oxide (SiO), silicon carbon nitride (SiCN), silicon boron nitride (SiBN), silicon oxynitride (SiON), silicon oxycarbonitride (SiOCN), silicon boron carbide nitride (SiBCN), silicon oxycarbide (SiOC), or a combination thereof. As used in this specification, the terms "silicon nitride (SiN)", "silicon oxide (SiO)", "silicon carbon nitride (SiCN)", "silicon boron nitride (SiBN)", "silicon oxynitride (SiON)", "silicon oxycarbonitride (SiOCN)", "silicon boron carbide nitride (SiBCN)", and "silicon oxycarbide (SiOC)" refer to materials consisting of elements included in each term, and are not chemical formulas that represent a stoichiometric relationship.

The second source/drain region 170 may be covered with an insulating liner 154. The insulating liner 154 may be made of silicon nitride (SiN), silicon oxide (SiO), silicon carbon nitride (SiCN), silicon boron nitride (SiBN), silicon oxynitride (SiON), silicon oxycarbonitride (SiOCN), silicon boron carbide nitride (SiBCN), silicon oxycarbide (SiOC), or a combination thereof. In some embodiments, the insulating liner 154 may be omitted. An inter-gate insulating film 155 may be disposed on the insulating liner 154. The inter-gate insulating film 155 may be made of a silicon nitride film, a silicon oxide film, silicon oxynitride (SiON), silicon oxycarbonitride (SiOCN), or a combination thereof. When the insulating liner 154 is omitted, the inter-gate insulating film 155 may contact the plurality of second source/drain regions 170.

The semiconductor device 100 illustrated in FIG. 1 may include the protective layer 121 including the indented structure ID, and the protective layer 121 may include silicon germanium or a material obtained by adding carbon to the silicon germanium. Owing to a strain compensation effect of germanium (Ge) and carbon (C), the possibility of plastic relaxation due to the addition of the protective layer 121 may be reduced/minimized, and when the first source/drain region 160 is grown, the occurrence of stacking faults may be reduced/prevented.

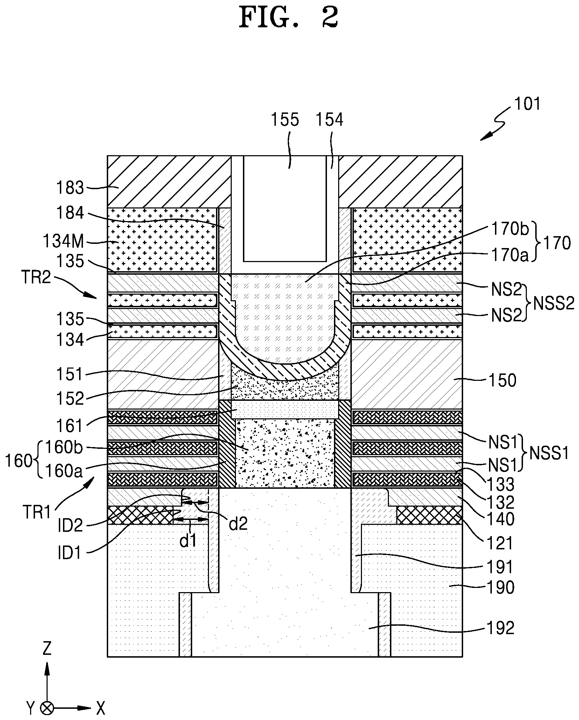

FIG. 2 is a cross-sectional diagram illustrating a semiconductor device according to an embodiment.

Referring to FIG. 2, a semiconductor device 101 may include a protective layer 121 including a first indented structure ID1, a dummy layer 140 formed on the protective layer 121 and including a second indented structure ID2, a first transistor TR1 formed on the dummy layer 140, and a second transistor TR2.

The semiconductor device 101 is the same as the semiconductor device 100 of FIG. 1, except that the second indented structure ID2 is formed in the dummy layer 140. In describing FIG. 2, content overlapping with that of FIG. 1 will be omitted.

The first indented structure ID1 may be formed in the protective layer 121. The first indented structure ID1 formed in the protective layer 121 may be filled with the spacer 191. The spacer 191 may include silicon nitride, but is not limited thereto. The spacer 191 may include, for example, silicon nitride (SiN), silicon dioxide (SiO₂), silicon oxycarbide (SiOC), silicon oxycarbonitride (SiOCN), or silicon oxynitride (SiON).

The second indented structure ID2 may be formed in the dummy layer 140. The second indented structure ID2 may be, for example, an opening in the dummy layer 140. The second indented structure ID2 formed in the dummy layer 140 may have the spacer 191 therein (e.g., may be filled with the spacer 191). The spacer 191 may include silicon nitride, but is not limited thereto. The spacer 191 may include, for example, silicon nitride (SiN), silicon dioxide (SiO₂), silicon oxycarbide (SiOC), silicon oxycarbonitride (SiOCN), or silicon oxynitride (SiON).

A depth d1 (in the direction X) of the first indented structure ID1 formed in the protective layer 121 may be larger than a depth d2 (in the direction X) of the second indented structure ID2 formed in the dummy layer 140. However, the embodiment is not limited to this, and a depth d1 of the first indented structure ID1 formed in the protective layer 121 may be the same as or be less than a depth d2 of the second indented structure ID2 formed in the dummy layer 140. The spacer 191 may contact both (i) an inner sidewall of the protective layer 121 that is indented by the depth d1 and (ii) an inner sidewall of the dummy layer 140 that is indented by the depth d2. The depths d1, d2 may each be distances (e.g., indentations) in the X direction relative to an inner sidewall of the gap-fill oxide layer 190, which may contact the spacer 191. As used herein, the term "indented" may refer to a portion (e.g., a sidewall) of a layer that is laterally recessed/offset relative to another layer.

The semiconductor devices 100 and 101 of the embodiment may include complementary field effect transistors (CFETs) including the first transistor TR1 and the second transistor TR2 vertically stacked.

FIGS. 3A to 3L are cross-sectional diagrams illustrating a process sequence to explain a method of manufacturing a semiconductor device according to an embodiment. An example method of manufacturing the semiconductor device 100 described with reference to FIG. 1 will be described with reference to FIGS. 3A to 3L. In FIGS. 3A to 3L, the same reference numerals as in FIG. 1 indicate the same elements, and a detailed description thereof is omitted here.

Referring to FIG. 3A, an etch stop layer 120, a silicon layer 111, a protective layer 121, and a dummy layer 140 may be sequentially formed on a substrate 110.

The substrate 110 may include one of a material having semiconductor properties (e.g., silicon, germanium), an insulating material (e.g., glass, quartz), a semiconductor covered by an insulating material, or a conductor. Here, the substrate 110 may include a wafer containing silicon (Si). In some embodiments, the substrate 110 may include a wafer including a semiconductor element such as germanium (Ge), or a compound semiconductor such as silicon carbide (SiC), gallium arsenide (GaAs), indium arsenide (InAs), or indium phosphide (InP). Meanwhile, the substrate 110 may include a silicon on insulator (SOI) structure.

The etch stop layer 120 may be made of a semiconductor material layer formed in an epitaxial growth method. The etch stop layer 120 may include silicon germanium or a material obtained by adding carbon to the silicon germanium. The silicon layer 111 may include silicon (Si).

A plurality of first sacrificial semiconductor layers 130 and a plurality of first nanosheets NS1 may be alternately stacked one layer at a time on the dummy layer 140 and then, an insulating layer 150 may be stacked on the uppermost first sacrificial semiconductor layer 130.

Thereafter, a plurality of second sacrificial semiconductor layers 131 and a plurality of second nanosheets NS2 may be alternately stacked one layer at a time on the insulating layer 150.

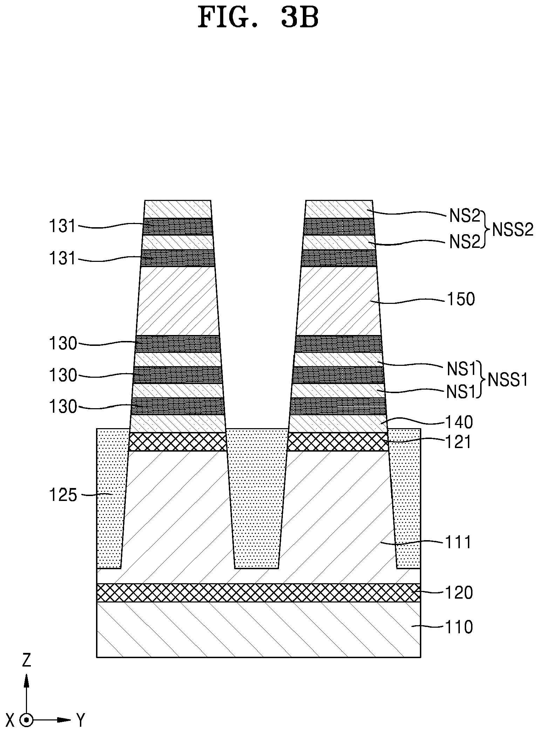

FIG. 3B is a diagram showing FIG. 3A viewed from an X-axis (i.e., viewed in a Y-Z plane). Referring to FIG. 3B, an oxide film 125 covering the silicon layer 111 may be formed. The oxide film 125 may be formed so that the protective layer 121 is not removed when the first sacrificial semiconductor layer 130 and the second sacrificial semiconductor layer 131 are removed. A vertical level of an upper surface of the oxide film 125 may be formed to be greater than a vertical level of an upper surface of the protective layer 121.

The dummy layer 140 may have a sufficient thickness to impede/prevent the protective layer 121 from being removed when the first sacrificial semiconductor layer 130 and the second sacrificial semiconductor layer 131 are removed. For example, the thickness of the dummy layer 140 may be about 10 nm or more and about 20 nm or less. As another example, the thickness of the dummy layer 140 may be about 5 nm or more and about 50 nm or less.

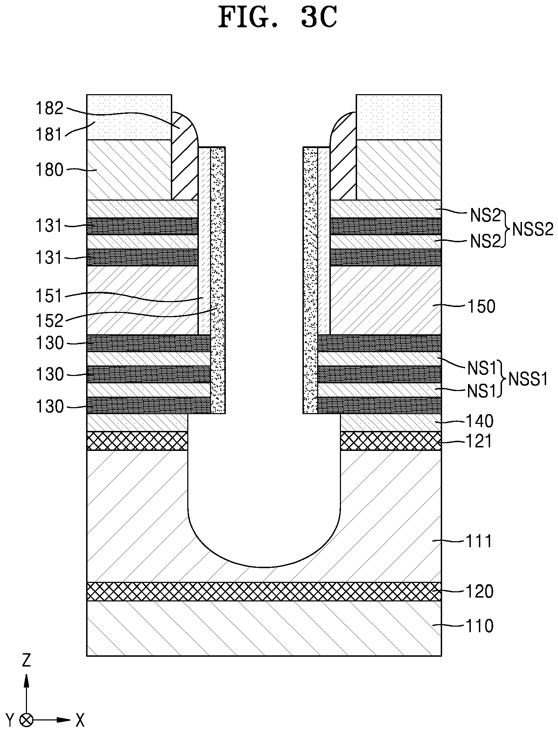

Referring to FIG. 3C, a dummy gate layer 180 and a dummy capping layer 181 may be sequentially stacked on the uppermost second nanosheet NS2, and a spacer film 182 may be formed to surround the dummy gate layer 180 and the dummy capping layer 181.

The dummy gate layer 180, the dummy capping layer 181, and the spacer film 182 may be used to etch a portion of each of the plurality of first sacrificial semiconductor layers 130, the plurality of first nanosheets NS1, the plurality of second sacrificial semiconductor layers 131, the plurality of second nanosheets NS2, the dummy layer 140, the protective layer 121, and the silicon layer 111.

Thereafter, a first insulating film 151 may be formed to conformally cover an etched surface of the plurality of second sacrificial semiconductor layers 131 and the plurality of second nanosheets NS2, and a second insulating film 152 may be formed to conformally cover the plurality of first sacrificial semiconductor layers 130 and the plurality of first nanosheets NS1. To form the first insulating film 151 and the second insulating film 152, an atomic layer deposition (ALD) process may be used.

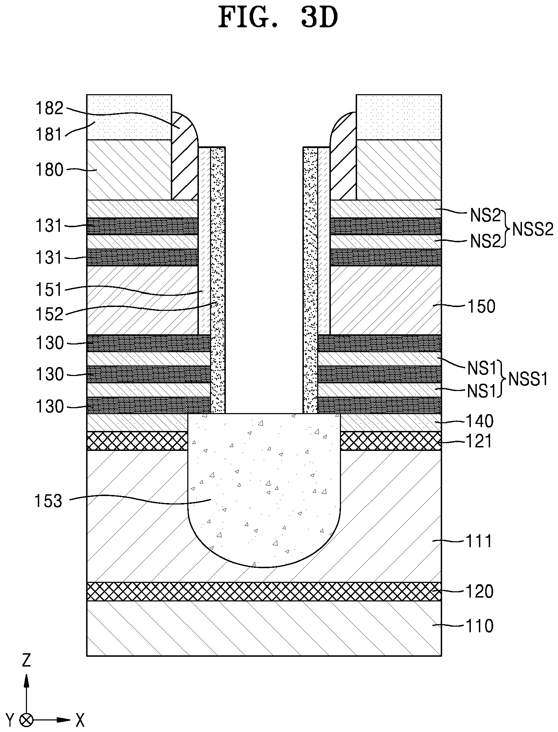

Referring to FIG. 3D, a place holder 153 (i.e., a sacrificial layer) may be formed on the silicon layer 111. The place holder 153 may be made of silicon germanium (SiGe) grown using the epitaxial growth method.

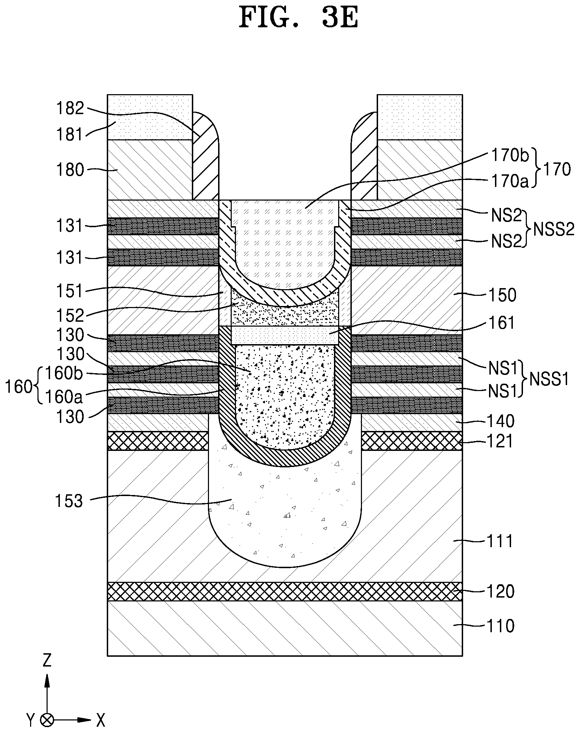

Referring to FIG. 3E, the first source/drain region 160 may be formed on the place holder 153. The upper surface of the first source/drain region 160 may be covered with the semiconductor capping layer 161. The second source/drain region 170 electrically insulated from the first source/drain region 160 may be formed above the first source/drain region 160.

The epitaxial growth of the place holder 153 and the first source/drain region 160 within a structure including the substrate 110, the etch stop layer 120, the silicon layer 111, and the protective layer 121 having the same crystallinity may progress, thereby reducing/preventing stacking faults.

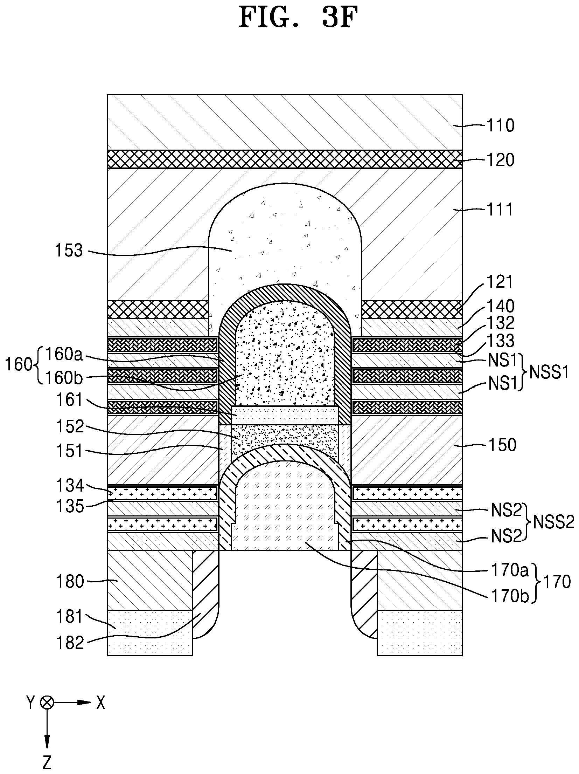

Referring to FIG. 3F, the first sacrificial semiconductor layer 130 and second sacrificial semiconductor layer 131 including silicon germanium (SiGe) may be removed. At this time, the protective layer 121 may not be removed due to the oxide film 125 of FIG. 3B.

The first gate line 132 may be formed in a portion/region where the first sacrificial semiconductor layer 130 has been removed, and the first gate dielectric film 133 may be formed to surround the first gate line 132. The second gate line 134 may be formed in a portion/region where the second sacrificial semiconductor layer 131 has been removed, and the second gate dielectric film 135 may be formed to surround the second gate line 134. Thereafter, the wafer may be turned over to form the contact electrode 192 described later.

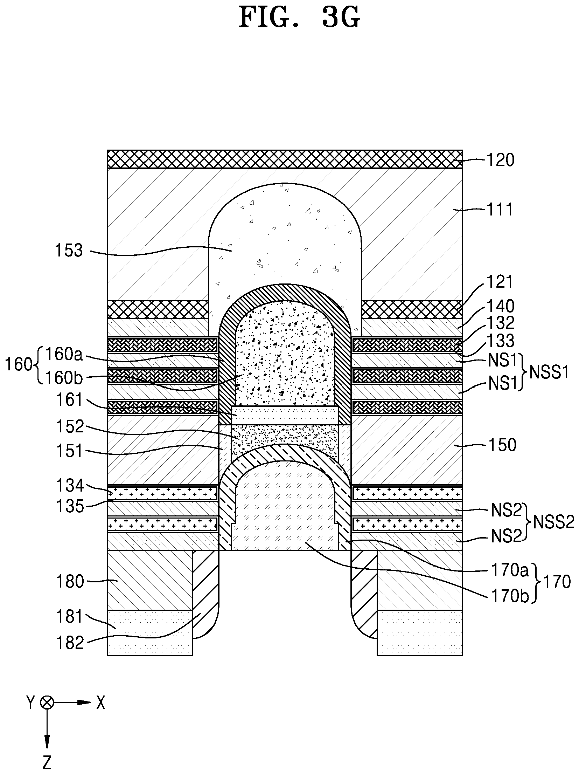

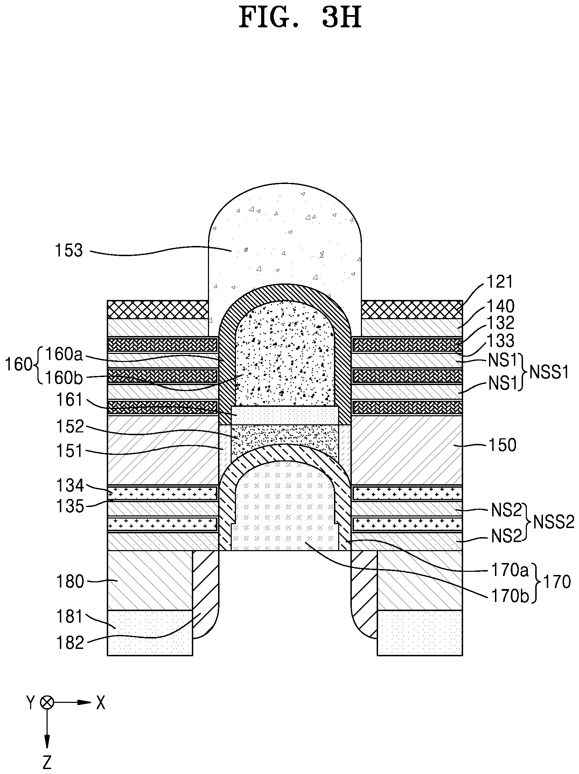

Referring to FIGS. 3G and 3H, after the wafer is turned over, the substrate 110 and the silicon layer 111 may be etched out.

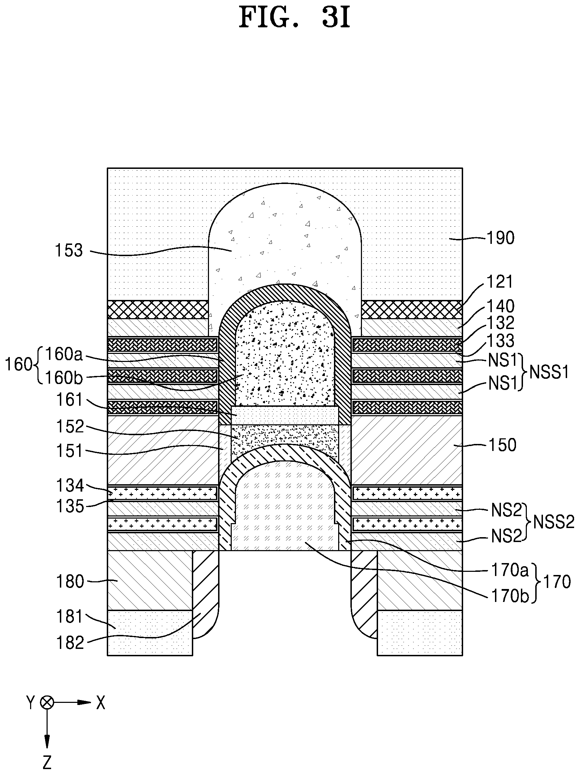

Referring to FIG. 3I, the gap-fill oxide layer 190 may be formed in a portion/region where the silicon layer 111 has been removed. The formed gap-fill oxide layer 190 may be planarized through a chemical mechanical polishing (CMP) process.

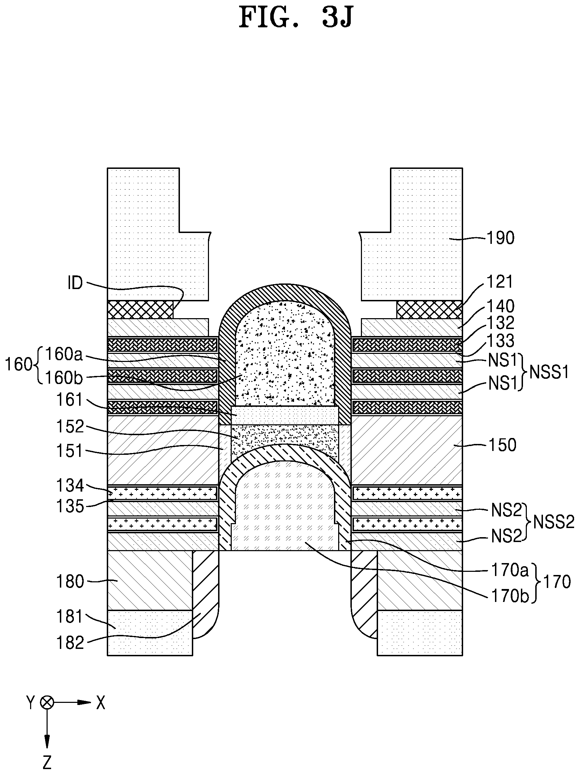

Referring to FIG. 3J, the indented structure ID may be formed by etching a portion of the gap-fill oxide layer 190 and etching a portion of the protective layer 121.

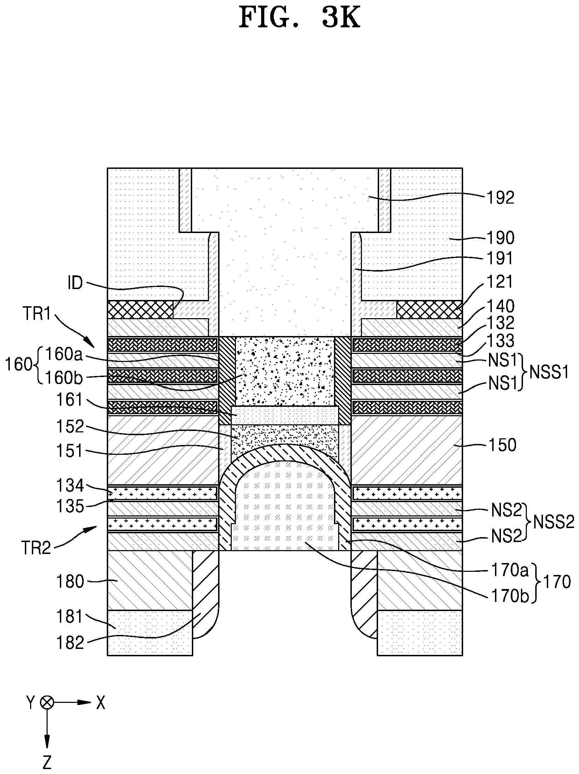

Referring to FIG. 3K, the spacer 191 may be formed in (e.g., to fill) the indented structure ID of the protective layer 121. The spacer 191 may be formed to contact the gap-fill oxide layer 190. Thereafter, the contact electrode 192 may be formed beneath the first source/drain region 160. The contact electrode 192 may be surrounded by the spacer 191.

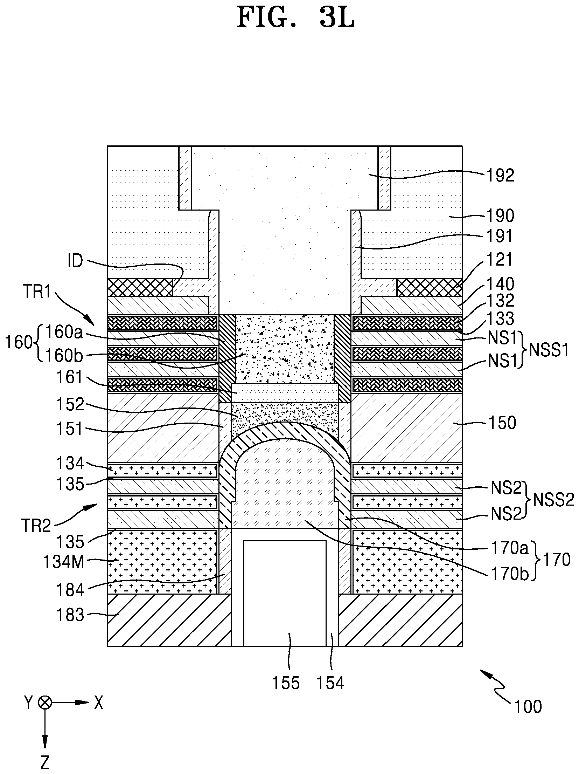

Referring to FIG. 3L, the dummy gate layer 180, the dummy capping layer 181, and the spacer film 182 may be removed, and the main gate line 134M and the second gate dielectric film 135 contacting the main gate line 134M may be formed in a removed portion. The plurality of main gate lines 134M may be covered with the capping insulating pattern 183, and a sidewall of the main gate line 134M may be covered with the insulating spacer 184. The insulating spacer 184 may be spaced apart from the main gate line 134M with the second gate dielectric film 135 located therebetween. The second source/drain region 170 may be covered with the insulating liner 154. The inter-gate insulating film 155 may be disposed on the insulating liner 154.

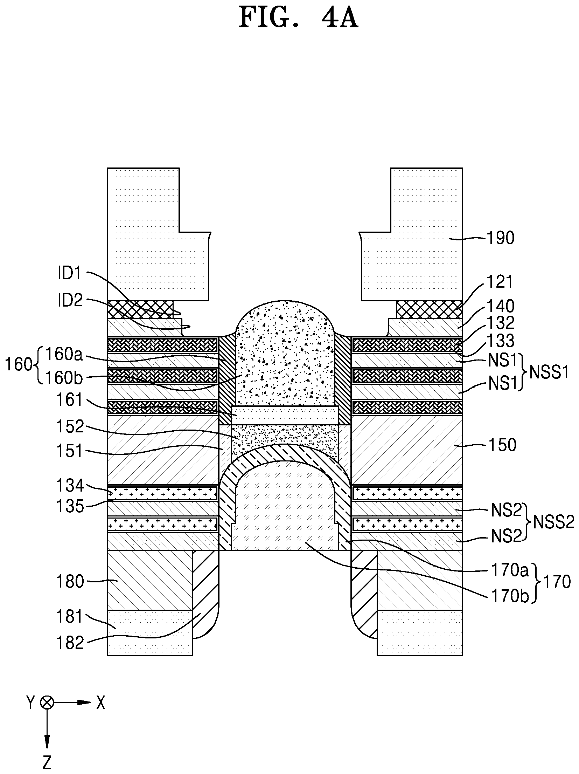

FIGS. 4A to 4C are cross-sectional views illustrating a process sequence to explain a method of manufacturing a semiconductor device according to other embodiments. For example, this process sequence may be used to form the semiconductor device 101 that is shown in FIG. 2. In FIGS. 4A to 4C, the same reference numerals as in FIGS. 1 and 2 indicate the same elements, and a detailed description thereof is omitted here.

The processes described with reference to FIGS. 3A to 3I may be performed before processes of FIGS. 4A to 4C.

Referring to FIG. 4A, a first indented structure ID1 may be formed by etching a portion of the gap-fill oxide layer 190 and etching a portion of the protective layer 121, and a second indented structure ID2 may be formed by etching a portion of the dummy layer 140.

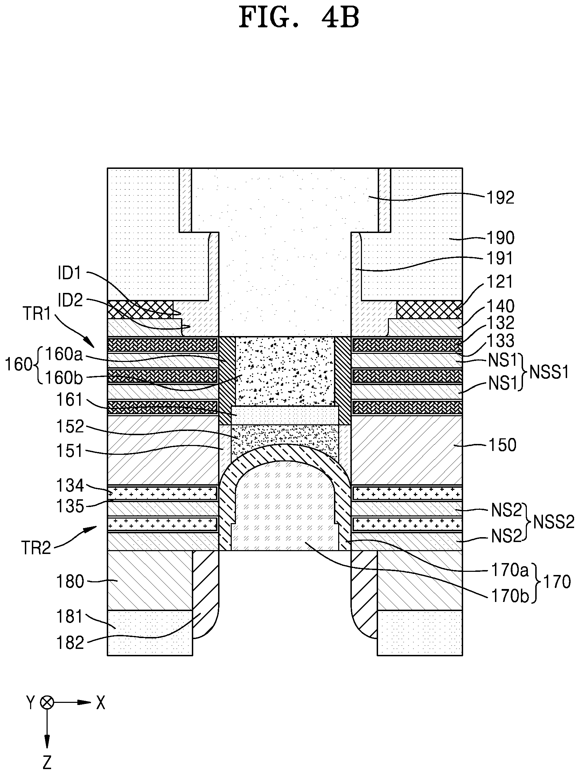

Referring to FIG. 4B, a spacer 191 may be formed to fill the first indented structure ID1 of the protective layer 121 and the second indented structure ID2 of the dummy layer 140. The spacer 191 may be formed to contact the gap-fill oxide layer 190. Thereafter, the contact electrode 192 may be formed beneath the first source/drain region 160. The contact electrode 192 may be surrounded by the spacer 191.

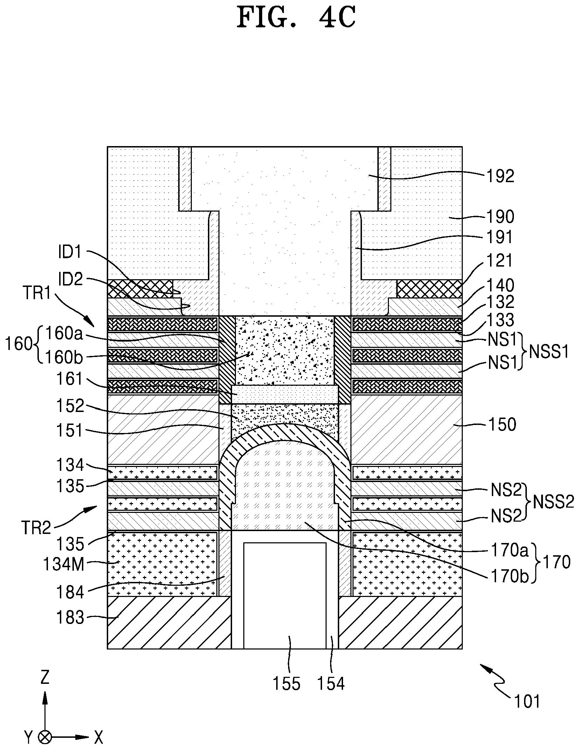

Referring to FIG. 4C, the dummy gate layer 180, the dummy capping layer 181, and the spacer film 182 may be removed, and the main gate line 134M and the second gate dielectric film 135 contacting the main gate line 134M may be formed in a removed portion. The plurality of main gate lines 134M may be covered with the capping insulating pattern 183, and a sidewall of the main gate line 134M may be covered with the insulating spacer 184. The insulating spacer 184 may be spaced apart from the main gate line 134M with the second gate dielectric film 135 located therebetween. The second source/drain region 170 may be covered with the insulating liner 154. The inter-gate insulating film 155 may be disposed on the insulating liner 154.

Above, example embodiments have been described with reference to the attached drawings, but those skilled in the art will understand that the inventive concept may be embodied in other specific forms without changing the technical idea or essential features. Therefore, it should be understood that the embodiments described above are illustrative and not restrictive in all respects.

While the inventive concept has been particularly shown and described with reference to example embodiments thereof, it will be understood that various changes in form and details may be made therein without departing from the scope of the following claims.

Embodiments are set out in the following clauses:
Clause 1: A semiconductor device comprising:
   a first transistor comprising a first channel region extending in a first direction and a first source/drain region contacting the first channel region;
   a second transistor comprising a second channel region on the first transistor and spaced apart from the first transistor in a second direction perpendicular to the first direction and extending in the first direction and a second source/drain region contacting the second channel region;
   a dummy layer beneath the first transistor;
   a protective layer beneath the dummy layer and comprising an indented portion that is indented in the first direction; and
   a spacer on the indented portion.
Clause 2: The semiconductor device of clause 1,
   wherein the protective layer comprises carbon and silicon germanium (SiGe), and
   wherein the indented portion of the protective layer comprises an inner sidewall of the protective layer that is indented in the first direction relative to an inner sidewall of the dummy layer.
Clause 3: The semiconductor device of clause 1 or 2,
   wherein the spacer comprises silicon nitride (SiN), and
   wherein a portion of the spacer protrudes in the first direction toward the indented portion of the protective layer.
Clause 4: The semiconductor device of any preceding clause,
   wherein the first source/drain region comprises epitaxial silicon germanium (SiGe).
Clause 5: The semiconductor device of any preceding clause,
   wherein the second source/drain region comprises epitaxial silicon (Si).
Clause 6: The semiconductor device of any preceding clause,
   wherein the first channel region comprises a plurality of first nanosheets spaced apart from each other in the second direction, and
   wherein the first transistor further comprises a plurality of first gate lines spaced apart from each other with the first nanosheets located therebetween.
Clause 7: The semiconductor device of clause 6,
   wherein the first source/drain region is in contact with each of the plurality of first nanosheets.
Clause 8: The semiconductor device of any preceding clause,
   wherein the second channel region comprises a plurality of second nanosheets spaced apart from each other in the second direction, and
   wherein the second transistor further comprises a plurality of second gate lines spaced apart from each other with the second nanosheets located therebetween.
Clause 9: The semiconductor device of any preceding clause,
   further comprising a contact electrode beneath the first source/drain region,
   wherein the contact electrode is surrounded by the spacer.
Clause 10: The semiconductor device of any preceding clause,
   wherein the dummy layer comprises silicon and has a thickness between about 10 nanometers (nm) and about 20 nm.
Clause 11: The semiconductor device of any preceding clause,
   wherein the first source/drain region comprises a first semiconductor layer and a second semiconductor layer on the first semiconductor layer, and
   wherein the first semiconductor layer and the second semiconductor layer comprise silicon germanium (SiGe).
Clause 12: The semiconductor device of clause 11,
   wherein a germanium content ratio of the first semiconductor layer is greater than a germanium content ratio of the second semiconductor layer.
Clause 13: The semiconductor device of any preceding clause,
   further comprising an insulating layer between the first transistor and the second transistor and insulating the first transistor and the second transistor from each other.
Clause 14: A semiconductor device comprising:
   a first transistor comprising a first channel region extending in a first direction and a first source/drain region contacting the first channel region;
   a second transistor comprising a second channel region on the first transistor and spaced apart from the first transistor in a second direction perpendicular to the first direction and extending in the first direction and a second source/drain region contacting the second channel region;
   a dummy layer beneath the first transistor and comprising a sidewall that is indented in the first direction;
   a protective layer beneath the dummy layer and comprising a sidewall that is indented in the first direction; and
   a spacer on the sidewall of the protective layer and on the sidewall of the dummy layer.
Clause 15: A semiconductor device comprising:
   a first transistor comprising a first channel region comprising a plurality of first nanosheets extending in a first direction and spaced apart from each other in a second direction perpendicular to the first direction, a first source/drain region contacting the first channel region, and a plurality of first gate lines surrounding the plurality of first nanosheets;
   a second transistor comprising a second channel region on the first transistor and spaced apart from the first transistor in the second direction and comprising a plurality of second nanosheets spaced apart from each other in the second direction, a second source/drain region contacting the second channel region, and a plurality of second gate lines spaced apart from each other with the second nanosheets located therebetween;
   an insulating layer between the first transistor and the second transistor and insulating the first transistor and the second transistor from each other;
   a contact electrode beneath the first source/drain region;
   a dummy layer beneath the first transistor;
   a protective layer beneath the dummy layer and comprising a sidewall that is indented in the first direction; and
   a spacer on the sidewall.

## Claims

1. A semiconductor device comprising:
a first transistor comprising a first channel region extending in a first direction and a first source/drain region contacting the first channel region;
a second transistor comprising a second channel region on the first transistor and spaced apart from the first transistor in a second direction perpendicular to the first direction and extending in the first direction and a second source/drain region contacting the second channel region;
a dummy layer beneath the first transistor;
a protective layer beneath the dummy layer and comprising an indented portion that is indented in the first direction; and
a spacer on the indented portion.

2. The semiconductor device of claim 1,
wherein the protective layer comprises carbon and silicon germanium (SiGe), and/or
wherein the indented portion of the protective layer comprises an inner sidewall of the protective layer that is indented in the first direction relative to an inner sidewall of the dummy layer.

3. The semiconductor device of claim 1 or 2,
wherein the spacer comprises silicon nitride (SiN), and/or
wherein a portion of the spacer protrudes in the first direction towards the indented portion of the protective layer.

4. The semiconductor device of any preceding claim,
wherein the first source/drain region comprises epitaxial silicon germanium (SiGe).

5. The semiconductor device of any preceding claim,
wherein the second source/drain region comprises epitaxial silicon (Si).

6. The semiconductor device of any preceding claim,
wherein the first channel region comprises a plurality of first nanosheets spaced apart from each other in the second direction, and optionally:
wherein the first transistor further comprises a plurality of first gate lines spaced apart from each other with the first nanosheets located therebetween.

7. The semiconductor device of claim 6,
wherein the first source/drain region is in contact with each of the plurality of first nanosheets.

8. The semiconductor device of any preceding claim,
wherein the second channel region comprises a plurality of second nanosheets spaced apart from each other in the second direction, and optionally:
wherein the second transistor further comprises a plurality of second gate lines spaced apart from each other with the second nanosheets located therebetween.

9. The semiconductor device of any preceding claim,
further comprising a contact electrode beneath the first source/drain region, and optionally:
wherein the contact electrode is surrounded by the spacer.

10. The semiconductor device of any preceding claim,
wherein the dummy layer comprises silicon and has a thickness between about 10 nanometers (nm) and about 20 nm.

11. The semiconductor device of any preceding claim,
wherein the first source/drain region comprises a first semiconductor layer and a second semiconductor layer inside the first semiconductor layer, and optionally:
wherein the first semiconductor layer and the second semiconductor layer comprise silicon germanium (SiGe).

12. The semiconductor device of claim 11,
wherein a germanium content ratio of the first semiconductor layer is greater than a germanium content ratio of the second semiconductor layer.

13. The semiconductor device of any preceding claim,
further comprising an insulating layer between the first transistor and the second transistor and insulating the first transistor and the second transistor from each other.

14. A semiconductor device comprising:
a first transistor comprising a first channel region extending in a first direction and a first source/drain region contacting the first channel region;
a second transistor comprising a second channel region on the first transistor and spaced apart from the first transistor in a second direction perpendicular to the first direction and extending in the first direction and a second source/drain region contacting the second channel region;
a dummy layer beneath the first transistor and comprising a sidewall that is indented in the first direction;
a protective layer beneath the dummy layer and comprising a sidewall that is indented in the first direction; and
a spacer on the sidewall of the protective layer and on the sidewall of the dummy layer.

15. A semiconductor device comprising:
a first transistor comprising a first channel region comprising a plurality of first nanosheets extending in a first direction and spaced apart from each other in a second direction perpendicular to the first direction, a first source/drain region contacting the first channel region, and a plurality of first gate lines surrounding the plurality of first nanosheets;
a second transistor comprising a second channel region on the first transistor and spaced apart from the first transistor in the second direction and comprising a plurality of second nanosheets spaced apart from each other in the second direction, a second source/drain region contacting the second channel region, and a plurality of second gate lines spaced apart from each other with the second nanosheets located therebetween;
an insulating layer between the first transistor and the second transistor and insulating the first transistor and the second transistor from each other;
a contact electrode beneath the first source/drain region;
a dummy layer beneath the first transistor;
a protective layer beneath the dummy layer and comprising a sidewall that is indented in the first direction; and
a spacer on the sidewall.

## Amended claims

### Amended claims in accordance with Rule 137(2) EPC.

1. A semiconductor device (100, 101) comprising:
a first transistor (TR1) comprising a first channel region extending in a first direction and a first source/drain region (160) contacting the first channel region;
a second transistor (TR2) comprising a second channel region on the first transistor (TR1) and spaced apart from the first transistor (TR1) in a second direction perpendicular to the first direction and extending in the first direction and a second source/drain region (170) contacting the second channel region;
a dummy layer (140) beneath the first transistor (TR1);
a protective layer (121) beneath the dummy layer (140) and comprising a first indented portion that is indented in the first direction, the protective layer (121) and the dummy layer (140) adjacent in the second direction,
a gap-fill oxide layer (190) beneath the protective layer (121);;
a spacer (191) on the indented portion; and
a contact electrode (192) beneath the first source/drain region (160),
wherein the first indented portion of the protective layer (121) comprises an inner sidewall of the protective layer (121) that is indented in the first direction relative to an inner sidewall of the gap-fill oxide layer (190),
wherein the dummy layer (140) comprises a second indented portion that is indented in the first direction,
wherein the second indented portion of the dummy layer (140) comprises an inner sidewall of the dummy layer (140) that is indented in the first direction relative to an inner sidewall of the gap-fill oxide layer (190), and
wherein a first portion of the spacer (191) protrudes in the first direction toward the first indented portion of the protective layer (121), and a second portion of the spacer (191) protrudes in the first direction toward the second indented portion of the dummy layer (140).

2. The semiconductor device (100, 101) of claim 1,
wherein the protective layer (121) comprises carbon and silicon germanium, SiGe.

3. The semiconductor device (100, 101) of claim 1 or 2,
wherein the spacer (191) comprises silicon nitride, SiN, and/or
wherein a portion of the spacer (191) protrudes in the first direction towards the first indented portion of the protective layer (121).

4. The semiconductor device (100, 101) of any preceding claim,
wherein the first source/drain region (160) comprises epitaxial silicon germanium, SiGe.

5. The semiconductor device (100, 101) of any preceding claim,
wherein the second source/drain region (170) comprises epitaxial silicon, Si.

6. The semiconductor device (100, 101) of any preceding claim,
wherein the first channel region comprises a plurality of first nanosheets (NS1) spaced apart from each other in the second direction, and optionally:
wherein the first transistor (TR1) further comprises a plurality of first gate lines (132) spaced apart from each other with the first nanosheets (NS1) located therebetween.

7. The semiconductor device (100, 101) of claim 6 or 7,
wherein the first source/drain region (160) is in contact with each of the plurality of first nanosheets (NS1).

8. The semiconductor device (100, 101) of any preceding claim,
wherein the second channel region comprises a plurality of second nanosheets (NS2) spaced apart from each other in the second direction, and optionally:
wherein the second transistor (TR2) further comprises a plurality of second gate lines (134) spaced apart from each other with the second nanosheets (NS2) located therebetween.

9. The semiconductor device (100, 101) of any preceding claim,
wherein the contact electrode (192) is surrounded by the spacer (191).

10. The semiconductor device (100, 101) of any preceding claim,
wherein the dummy layer (140) comprises silicon and has a thickness between about 10 nanometers, nm, and about 20 nm.

11. The semiconductor device (100, 101) of any preceding claim,
wherein the first source/drain region (160) comprises a first semiconductor layer (160a) and a second semiconductor layer (160b) inside the first semiconductor layer (160a), and optionally:
wherein the first semiconductor layer (160a) and the second semiconductor layer (160b) comprise silicon germanium, SiGe.

12. The semiconductor device (100, 101) of claim 13,
wherein a germanium content ratio of the first semiconductor layer (160a) is greater than a germanium content ratio of the second semiconductor layer (160b).

13. The semiconductor device (100, 101) of any preceding claim,
further comprising an insulating layer (150) between the first transistor (TR1) and the second transistor (TR2) and insulating the first transistor (TR1) and the second transistor (TR2) from each other.

14. The semiconductor device (100, 101) of claim 1, wherein a depth (d1) in the first direction of the first indented portion formed in the protective layer (121) is larger than a depth (d2) in the first direction of the second indented portion formed in the dummy layer (140).

15. The semiconductor device (100, 101) of claim 1, wherein a depth (d1) in the first direction of the first indented portion formed in the protective layer (121) is the same as or less than a depth (d2) in the first direction of the second indented portion formed in the dummy layer (140).
